(19) Europäisches Patentamt
European Patent Office
Office européen des brevets

(11) Veröffentlichungsnummer : **0 599 069 B1**

# (12) EUROPÄISCHE PATENTSCHRIFT

(45) Veröffentlichungstag der Patentschrift :
**27.12.95 Patentblatt 95/52**

(51) Int. Cl.$^{6}$ : **G03F 7/033,** G03F 7/028, G03F 7/004

(21) Anmeldenummer : **93117365.2**

(22) Anmeldetag : **27.10.93**

## (54) Lichtempfindliches Aufzeichnungsmaterial

(30) Priorität : **26.11.92 DE 4239660**

(43) Veröffentlichungstag der Anmeldung :
**01.06.94 Patentblatt 94/22**

(45) Bekanntmachung des Hinweises auf die Patenterteilung :
**27.12.95 Patentblatt 95/52**

(84) Benannte Vertragsstaaten :
**DE FR GB IT**

(56) Entgegenhaltungen :
**EP-A- 0 081 964**
**EP-A- 0 266 069**

(73) Patentinhaber : **BASF Lacke + Farben AG**
**Glasuritstrasse 1**
**D-48165 Münster-Hiltrup (DE)**

(72) Erfinder : **Bronstert, Bernd, Dr.**
**Zanderstrasse 35**
**D-67166 Otterstadt (DE)**
Erfinder : **Littmann, Dieter, Dr.**
**Neckarpromenade 36**
**D-68167 Mannheim (DE)**

(74) Vertreter : **Karau, Wolfgang, Dr. et al**
**BASF Aktiengesellschaft,**
**Patentabteilung ZDX - C 6**
**D-67056 Ludwigshafen (DE)**

EP 0 599 069 B1

Anmerkung : Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

## Beschreibung

Die Erfindung betrifft ein lichtempfindliches Aufzeichnungsmaterial auf Basis eines Gemisches aus polymerem Bindemittel, polymerisierbaren ethylenisch ungesättigten organischen Verbindungen und Weichmacher, das mindestens einen Photopolymerisationsinitiator sowie gegebenenfalls weitere Hilfs- und Zusatzstoffe enthält, wobei als polymeres Bindemittel ein teilverseifter Polyvinylcarbonsäureester, dessen Derivate oder teilverseifte Polyvinylcarbonsäureestercopolymere, als polymerisierbare ethylenisch ungesättigte organische Verbindungen Ester der Acryl- oder Methacrylsäure mit ein oder mehrwertigen Alkoholen und als Weichmacher spezielle Glycerinderivate eingesetzt werden.

Der Firmenschrift Moviol® Polyvinylalkohol der Fa. Hoechst AG ist der Zusatz von Glycerin, Trimethylolpropan, Neopentylglykol, Di- und Triglykol, Triethanolamin und oxethylierten Phosphorsäureestern als Weichmacher für voll- und teilverseifte Polyvinylalkohole zu entnehmen.

Für lichtempfindliche Aufzeichnungsmaterialien sind jedoch derartige Weichmacherzusätze wegen ihrer Flüchtigkeit, ihrer leichten Extrahierbarkeit und Erhöhung der Hydrophilie, die zur Erhöhung der Quellwerte und zur Extraktion von Weichmacheranteilen beim Auswachsschritt führt, problematisch. Extrahierbare Anteile fuhren bei der Druckformherstellung zu runden Reliefschultern und eingefallenen Negativschriften. Diese Extraktion läßt sich durch eine Verlängerung der Belichtungszeit, die aus Zeitgründen unerwünscht ist, nur teilweise und in ungenügendem Umfang unterdrücken. Weitere Nachteile derartiger Kombinationen sind ihre ungenügende Flexibilisierung und ihre erhöhte Klebrigkeit, die ihre Verwendbarkeit für Mehrfachkopien mit demselben Filmnegativ zumindest sehr einschränken.

Auch Diglycerin und höhere Oligomere des Glycerins wurden bereits als Weichmacher für photosensitive Polymere bzw. für Druckplatten (vgl. JP 7577363 und EP-A-081 964) vorgeschlagen.

So sind aus der EP 0 081 964 lichtempfindliche Gemische, enthaltend teilweise verseiftes Polyvinylacetat mit einem Verseifungsgrad von 60 bis 90 mol-%, mehrfunktionelle Acrylate oder Methacrylate mit Molekulargewichten bis zu 2000 und eine gesättigte Verbindung aus der Gruppe Ethylenglykol, Diethylenglykol, Triethylenglykol, Glycerin, Diglycerin, Trimethylolpropan und Trimethylolethan thylolethan bekannt, wobei diese gesättigten Verbindungen Molekulargewichte von möglichst nicht mehr als 1000, insbesondere Molekulargewichte zwischen 50 und 100 aufweisen sollen, um mit den anderen Komponenten dieser Gemische genügend verträglich zu sein.

Aus der JP 63253350 ist der Zusatz von Alkanolaminen zu Polyvinylalkohol-haltigen Druckplatten bekannt.

Die Di- und Polyglycerine haben im Gegensatz zu den bisher verwendeten und bekannten Weichmachern den Vorteil einer höheren Molmasse und damit eine geringe Flüchtigkeit und zeigen gute Verträglichkeit; nachteilig ist jedoch ihre hohe Hydrophilie und die damit verbundene erhöhte Extraktion, besonders im Bereich niedriger Lichtintensität, die wiederum durch eine Verlängerung der Belichtungszeit kompensiert werden muß.

Aufgabe der vorliegenden Erfindung ist es, lichtempfindliche Aufzeichnungsmaterialien und daraus herstellbare wasserauswaschbare Reliefdruckplatten aufzuzeigen, die die oben geschilderten Nachteile des bekannten Standes der Technik nicht oder nur im wesentlich geringerem Ausmaß aufweisen.

Die Lösung dieser Aufgabe gelingt überraschenderweise durch den Einsatz von Ethoxylierungs- oder Propoxylierungsprodukten des Glycerins, die pro Mol Glycerin 4 bis 18 Mol Ethylenoxid oder Propylenoxid an eine oder mehrere Hydroxylgruppen des Glycerins addiert enthalten.

Gegenstand der vorliegenden Erfindung ist daher ein lichtempfindliches Aufzeichnungsmaterial auf Basis eines Gemisches aus polymerem Bindemittel (a), polymerisierbaren ethylenisch ungesättigten organischen Verbindungen (b) und Weichmacher (c), das zusätzlich mindestens einen Photopolymerisationsinitiator sowie gegebenenfalls weitere übliche Zusatz- und Hilfsstoffe enthält und dadurch gekennzeichnet ist, daß es als polymeres Bindemittel (a) teilverseifte Polyvinylcarbonsäureester, Derivate teilverseifter Polyvinylcarbonsäureester oder teilverseifte Polyvinylcarbonsäureestercopolymere, als polymerisierbare ethylenisch ungesättigte organische Verbindungen (b) mindestens ein Umsetzungsprodukt der Acryl- oder Methacrylsäure mit ein- oder mehrwertigen Alkoholen, Amin- oder Epoxidverbindungen sowie als Weichmacher (c) mindestens ein Ethoxylierungs- oder Propoxylierungsprodukt des Glycerins enthält, in dem pro Mol Glycerin 4 bis 18 Mol Ethylenoxid oder Propylenoxid an eine oder mehrere Hydroxylgruppen des Glycerins addiert sind, und dieser Weichmacher (c) im lichtempfindlichen Aufzeichnungsmaterial in Mengen von mindestens 5 bis höchstens 25 Gew.-%, bezogen auf die Gesamtmenge der Komponenten (a)+(b)+(c), enthalten ist.

Gegenstand der vorliegenden Erfindung ist auch ein Verfahren zur Herstellung von wasserauswaschbaren Reliefdruckplatten, im wesentlichen bestehend aus einem Träger, einer Haftschicht und einer darauf angebrachten lichtstrukturierbaren Schicht, das dadurch gekennzeichnet ist, daß als lichtstrukturierbare Schicht das erfindungsgemäße lichtempfindliche Aufzeichnungsmaterial eingesetzt wird.

Die erfindungsgemäß eingesetzten Ethoxylierungs- bzw. Propoxylierungsprodukte des Glycerins weisen nur sehr geringe Flüchtigkeit auf und sind mit den Komponenten (a) und (b) des erfindungsgemäßen lichtempfindlichen Aufzeichnungsmaterials sehr gut verträglich. Von wesentlicher Bedeutung ist außerdem, daß sie Quellung und Extraktion der aus den erfindungsgemäß hergestellten Druckplatten erhaltenen Druckformen nicht negativ beeinflussen.

Die erfindungsgemäßen lichtempfindlichen Aufzeichnungsmaterialien weisen sowohl produktionstechnische als auch anwendungstechnische Vorteile auf. So ist es z.B. bei der Herstellung der erfindungsgemäßen Aufzeichnungsmaterialien möglich, infolge der Absenkung der Ansatzviskosität höhere Feststoffkonzentrationen einzustellen, und es lassen sich verkürzte Trockenzeiten, höhere Produktionsgeschwindigkeiten, verringerte Dickentoleranzen, besserer Verlauf der Gießlösung und damit nicht nur Einsparung an Energiekosten sondern bei der Weiterverarbeitung auch verbesserte Druckergebnisse erzielen.

An anwendungstechnischen Vorteilen der erfindungsgemäßen lichtempfindlichen Aufzeichnungsmaterialien sind zu nennen
eine dauerhafte Flexibilisierung der Druckplatten, die ihre wiederholte Verwendung in der Druckmaschine ermöglicht,
eine Verkürzung der Entwicklungszeiten ohne Erhöhung der Quellung,
eine Verringerung der Wascherverschmutzung, die Möglichkeit einer Erhöhung des Feststoffanteils in der Entwicklerlösung,
eine Verringerung der Schaumentwicklung beim Auswaschen,
eine Verbesserung der drucktechnischen Eigenschaften,
eine Verringerung des Beistelldrucks in den Druckmaschinen,
eine Verringerung des Verschleißes der Gegendruckgummitücher,
eine Verbesserung der Farbübertragung,
ein volleres Ausdrucken von Flächen und feineres Ausdrucken von Spitzlichtern sowie eine Erhöhung der Standfestigkeit.

Das sehr erwünschte bessere Ausdrucken feiner Spritzlichter mag seine Ursache in dem niedrigeren Beistelldruck und/oder dem besseren Farbannahme/Farbabgabe-Verhalten der Klischees haben.

Die erfindungsgemäß hergestellten Druckplatten eignen sich insbesondere für wasserentwickelbare Zeitungs- und Accidenzdruckplatten.

Zu den Aufbaukomponenten der erfindungsgemäßen lichtempfindlichen Aufzeichnungsmaterialien ist im einzelnen folgendes auszuführen.

Als polymere Bindemittel (a) werden für die erfindungsgemäßen lichtempfindlichen Aufzeichnungsmaterialien teilverseifte Polyvinylcarbonsäureester, Derivate der teilverseiften Polyvinylcarbonsäureester sowie teilverseifte Polyvinylcarbonsäureestercopolymere eingesetzt.

Als teilverseifte Polyvinylcarbonsäureester eignet sich beispielsweise teilverseiftes Polyvinylacetat oder Polyvinylpropionat, deren Estergruppen zu 70 bis 95, vorzugsweise 75 bis 90 mol-% verseift sind und die mittlere Molekulargewichte $\overline{M}_w$ zwischen 5.000 und 100.000, vorzugsweise zwischen 10.000 und 70.000 aufweisen.

Als Derivate der teilverseiften Polyvinylcarbonsäureester sowie teilverseifte Polyvinylcarbonsäureestercopolymere kommen in Frage: wasserlösliche Copolymere oder Derivate des Polyvinylalkohols, beispielsweise in wäßrigen Lösungsmitteln lösliche oder dispergierbare elastomere Pfropfpolymerisate, die durch Polymerisation von Vinylestern in Gegenwart von Polyalkylenoxiden und einem Initiator der radikalischen Polymerisation, Verseifen oder Teilverseifen des resultierenden Pfropfcopolymerisats und gegebenenfalls anschließendes Verestern oder Umestern von Vinylalkohol-Einheiten des verseiften oder teilverseiften Pfropfcopolymerisats hergestellt sind und im wesentlichen bestehen aus Struktureinheiten der Zusammensetzung

$$-(CH_2-\underset{\underset{R^1}{|}}{CH}-O)_n- \quad \text{und/oder} \quad -(\underset{\underset{Z}{|}}{CH_2}-\underset{\underset{R^1}{|}}{CH}-O)_m- ,$$

worin Z aufgepfropfte Seitenzweige mit Struktureinheiten

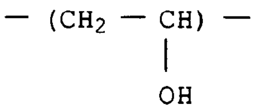 und ggf. 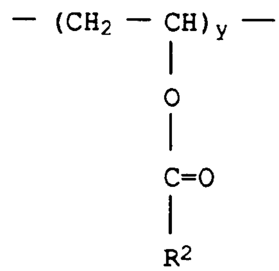 ,

$R^1$ Wasserstoff und/oder Alkylreste mit 1 oder 2 C-Atomen,
$R^2$ Alkyl- und/oder Alkenylreste, gegebenenfalls mit Carboxylsubstituenten, darstellen,
und $x > y$, $n > m$, m mindestens 2, $n + m = 20\text{-}2000$, und

$$\frac{(n+m)}{(x+y)} = \frac{1}{4} \text{ bis } \frac{3}{1}$$

sind,
wie sie in EP-A-224 164 beschrieben sind.

Ebenso eignen sich mit Methacrylsäure teilweise veresterte Polyvinylalkohole, wie sie in EP-A-220 507 bzw. DE-A-33 22 983 beschrieben sind, sowie teilacetalisierter Polyvinylalkohol. Derartige geeignete Polyvinylalkohole weisen im allgemeinen Molekulargewichte $\overline{M}_n$ zwischen 4000 und 100.000, vorzugsweise zwischen 10.000 und 70.000 auf.

Beispiele für bevorzugte polymere Bindemittel (a) sind teilverseiftes Polyvinylacetat mit einem Hydrolysegrad von ca. 82 mol-% und einem mittleren Molekulargewicht $\overline{M}_w$ von ca. 15.000 sowie Gemische eines derartigen teilverseiften Polyvinylacetats mit methacrylestergruppenhaltigen teilverseiftem Polyvinylacetat ($\overline{M}_w$ zwischen 4.000 und 100.000, vorzugsweise zwischen 10.000 und 70.000; Acetatgruppengehalt zwischen 5 und 40 mol-%, vorzugsweise zwischen 10 und 25 mol-%; Methacrylestergruppengehalt zwischen 1 und 30, vorzugsweise zwischen 2 und 10 mol-%) sowie gegebenenfalls statistischen Polyethylenoxid/Polyvinylalkohol/Polyvinylacetat-Copolymeren ($\overline{M}_w$ der Polyethylenoxidblöcke 2.000 bis 100.000, vorzugsweise 20.000 bis 50.000, 20 bis 80 mol-%, vorzugsweise 40 bis 70 mol-% Polyvinylalkohol-Seitenketten mit $\overline{M}_w$ 5.000 bis 100.000, vorzugsweise 10.000 bis 30.000, Restacetatgruppen 5 bis 30 mol-%, vorzugsweise 10 bis 20 mol-%) sowie Gemische von mindestens zwei der obengenannten Bindemittel.

Die Herstellung von mit Acylierungsmitteln, wie z.B. Acrylsäureanhydrid oder Methacrylsäureanhydrid, teilweise veresterten Polyvinylalkoholen, die radikalisch polymerisierbare Gruppen eingebaut enthalten, kann vorzugsweise auch in heterogener Phase in einem aprotischen Dispergiermittel, wie beispielsweise in EP-A-0079514 beschrieben, durchgeführt werden.

Das polymere Bindemittel (a) ist im erfindungsgemäßen lichtempfindlichen Aufzeichnungsmaterial im allgemeinen in einer Menge von 30 bis 90, vorzugsweise 45 bis 70 Gew.-%, bezogen auf die Gesamtmenge der Komponenten (a)+(b)+(c) enthalten.

Als polymerisierbare ethylenisch ungesättigte organische Verbindungen (b) kommen Ester der Acryl- und/oder Methacrylsäure mit ein- oder mehrwertigen Alkoholen, Amin- oder Epoxidverbindungen in Frage.

Beispiele sind monomere Di- und Polyacrylate und -methacrylate, wie sie durch Veresterung von Diolen oder Polyolen mit Acrylsäure oder Methacrylsäure hergestellt werden können, wie die Di- bzw. Tri(meth)acrylate von Ethylenglykol, Diethylenglykol, Triethylenglykol oder Polyethylenglykolen mit einem Molekulargewicht bis etwa 500, 1,2-Propandiol, Neopentylglykol, (2,2-Dimethylpropandiol), 1,4-Butandiol, 1,1,1-Trimethylolpropan, Glycerin oder Pentaerythrit, ferner die Monoacrylate und Monomethacrylate solcher Diole und Polyole, wie z.B. Ethylenglykol-, Di-, Tri- oder Tetraethylenglykolmonoacrylat, Monomere mit zwei oder mehr olefinisch ungesättigten Bindungen, die Urethangruppen und/oder Amidgruppen enthalten, wie die aus aliphatischen Diolen der vorstehend genannten Art, organischen Diisocyanaten und Hydroxyalkyl(meth)acrylaten hergestellten niedermolekularen Verbindungen. Genannt seien auch Acrylsäure, Methacrylsäure sowie deren Derivate wie (Meth)acrylamid, N-Hydroxymethyl(meth)acrylamid oder die (Meth)acrylate von Monoalkoholen mit 1 bis 6 C-Atomen.

Geeignete Monomere sind außerdem Umsetzungsprodukte von Glycidylethern mit Acrylsäure oder Methacrylsäure, wie z.B. Umsetzungsprodukte von Bisphenol-A-diglycidylether oder Butandioldiglycidylether mit Acrylsäure oder Methacrylsäure, sowie Gemische mit den obengenannten Monomeren.

Die polymerisierbaren ethylenisch ungesättigten organischen Verbindungen (b) sind im erfindungsgemäßen lichtempfindlichen Aufzeichnungsmaterial im allgemeinen in einer Menge von 10 bis 60, vorzugsweise 20 bis 50 Gew.-%, bezogen auf die Gesamtmenge der Komponenten (a) + (b) + (c) enthalten.

Als Weichmacher (c) werden erfindungsgemäß Ethoxylierungs- oder Propoxylierungsprodukte des Glycerins eingesetzt, die pro Mol Glycerin 4 bis 18, vorzugsweise 6 bis 14 Ethylenoxid- oder Propylenoxideinheiten an eine oder mehrere Hydroxylgruppen des Glycerins addiert enthalten; besonders bevorzugt sind Ethoxylierungsprodukte des Glycerins, die einen mittleren Ethoxylierungsgrad von 10 aufweisen.

Alkylenoxidaddukte des Glycerins mit einem Alkoxylierungsgrad < 4 sind weniger geeignet, da sie beim Auswaschprozeß in zu hohem Maße extrahiert werden und in den Druckformen eingefallene Schultern resultieren; Alkylenoxidaddukte des Glycerins mit einem Alkoxylierungsgrad > 18 lassen in ihrer Verträglichkeit mit den anderen Komponenten des lichtempfindlichen Aufzeichnungsmaterials sowie in ihrer weichmachenden Wirkung zu wünschen übrig.

Die Herstellung der erfindungsgemäßen Weichmacher (c) kann entsprechend der Umsetzung von Alkylenoxiden mit mehrwertigen Alkoholen erfolgen, wie sie beispielsweise in Houben-Weyl, Methoden der organischen Chemie, 4. Auflage, Band XIV/2, Seiten 425-462 bzw. Band VI/3, Seite 485 ff. beschrieben ist.

Der Weichmacher (c) ist im erfindungsgemäßen lichtempfindlichen Aufzeichnungsmaterial in Mengen von mindestens 5 bis höchstens 25 Gew.-%, bezogen auf die Gesamtmenge der Komponenten (a)+(b)+(c) enthalten, wobei jeweils die Summe der unter (a) bis (c) angegebenen Prozentzahlen 100 ist.

Als weitere Bestandteile kommen in Frage Photoinitiatoren oder Photoinitiatorsysteme, Inhibitoren gegen die thermische Polymerisation, Lösungsmittel, wäßrige oder organische Lösungsmittelgemische sowie Zusätze zur Erzielung besonderer Effekte, beispielsweise Reglerfarbstoffe/Reglersysteme zur Beeinflußung der Photopolymerisations-Gradation oder reaktive Aldehyde wie Glyoxal oder Glutardialdehyd, mit denen die Lösegeschwindigkeit der Polyvinylalkholbindemittel gezielt verringert werden kann.

Photoinitiatoren sind im allgemeinen in Mengen von 0,01 bis 10 und insbesondere 0,01 bis 3 Gew.-%, bezogen auf die Gesamtmenge der Komponenten (a)+(b)+(c) vorhanden. Als Photoinitiatoren sind dabei solche Verbindungen geeignet, die bei Einwirkung von aktinischem Licht Radikale zu bilden vermögen und eine rasche Photopolymerisation in der Schicht auslösen. Als Photoinitiatoren kommen z.B. in Frage Acyloine und Acyloinether, aromatische Diketone und deren Derivate und mehrkernige Chinone. Sehr geeignet sind Benzoin und $\alpha$-Hydroxymethyl-benzoinmethylether oder Benzoinmethylether, Benzoinisopropylether, Benzilmonoketale wie Benzildimethylketal, Benzil-methyl-ethylketal, Benzil-methyl-benzylketal, Benzil-neopentylketal oder Diarylphosphinoxide, wie sie in der DE-OS 29 09 992 beschrieben sind, vorzugsweise 2,6-Dimethoxybenzoyldiphenylphosphinoxid und insbesondere 2,4,6-Trimethylbenzoyl-diphenylphosphinoxid. Bevorzugt sind Photoinitiatoren in Art und Menge, daß sie für die Auslösung der Photopolymerisation bei bildmäßiger Belichtung mit aktinischem Licht, insbesondere UV-Licht, nur kurze Mindestbelichtungszeiten, bevorzugt nicht mehr als wenige Minuten benötigen.

Das erfindungsgemäße lichtempfindliche photopolymerisierbare Aufzeichnungsmaterial kann außerdem zweckmäßigerweise auch Inhibitoren gegen die thermische Polymerisation, wie Hydrochinon, p-Methoxyphenol, Dinitrobenzol, p-Chinon, Methylenblau, $\beta$-Naphthol, N-Nitrosamine wie N-Nitrosodiphenylamin, Phenothiazin, Phosphorigsäureester wie Triphenylphosphit oder die Salze und insbesondere die Alkali- und Aluminiumsalze des N-Nitroso-cyclohexylhydroxylamins enthalten. Die Inhibitoren können den photopolymerisierbaren Mischungen in Mengen von 0,001 bis 3, vorzugsweise 0,01 bis 1 Gew.-%, bezogen auf die Gesamtmenge der Komponenten (a)+(b)+(c), zugesetzt werden.

Das lichtempfindliche Aufzeichnungsmaterial kann auch noch ein Reglersystem enthalten, wie es beispielsweise in EP-A-114 341 beschrieben ist.

Dies sind Mischungen bestimmter Farbstoffe (1) mit milden Reduktionsmitteln (2) für den mitverwendeten jeweiligen Farbstoff (1) (vgl. auch EP-A-0 114 341).

Als Farbstoffe (1) für die photopolymerisierbaren Mischungen der reliefbildenden Schicht eignen sich vor allem solche aus der Reihe der Phenoxazinfarbstoffe, wie z.B.

Capriblau GN (C.I. 51000), Zaponechtblau 3 G (C.I. 51005), Galloblau E (C.I. 51040), Echtneublau 3 R (C.I. 51175), Nilblau A (C.I. 51180), Echtgrün M (C.I. 51210), Echtschwarz L (C.I. 51215) sowie Rhodanilblau, dem Salz bzw. Amid aus Rhodamin B (Basic Violet 10, C.I. 45170) und Nilblau (Basic Blue 12, C.I. 51180), Verbindungen aus der Reihe der Phenaziniumfarbstoffe, wie z.B. Neutralrot (C.I. 50040), Neutralviolett (C.I. 50030), Azinscharlach G (C.I. 50045), Rhodulinheliotrop 3 B (C.I. 50055), Neutralblau C (C.I. 50150), Azingrün GB (C.I. 50155), Safranin B (C.I. 50200), Indaminblau B (C.I. 50204), Rhodulinrot G (C.I. 50215), Rhodulinblau GG extra (C.I. 50220), Indazin GB (C.I. 50221), Safranin T (C.I. 50240), Mauvein (C.I. 50245), Naphthylrot (C.I. 50370) sowie Nigroinschwarz T (C.I. 50415), Acridiniumfarbstoffe wie z.B. Acrifavin (C.I. 46000), Acridinorange (C.I. 46005), Acridinscharlach J (C.I. 46015), Acridingelb G (C.I. 46025), Aurazin G (C.I. 46030), Diamantphosphin GG (C.I. 46035), Phosphin E (C.I. 46045), Flaveosin (C.I. 46060), Benzoflavin (C.I. 46065) und Rheonin A (C.I. 46075), ferner Phenothiaziniumfarbstoffe, wie z.B. Methylenblau oder Thionin. Ebenso eignet sich (Isobutylthio)anthrachinon als Farbstoff (1).

Die Auswahl des verwendeten Farbstoffs (1) wird vor allem vom ästhetischen Eindruck mitbestimmt. So ist z.B. eine visuelle Beurteilung der Druckplatten besonders einfach mit den Verbindungen Neutralrot (C.I.

50040), Safranin T (C.I. 50240) sowie Rhodanilblau, die bevorzugt in der photopolymerisierbaren Mischung verwendet werden.

Das lichtempfindliche Aufzeichnungsmaterial kann also in Kombination mit dem Farbstoff (1) eine für diesen hinreichende Menge eines Reduktionsmittels (2) für den Farbstoff (1) enthalten, das den mitverwendeten Farbstoff (1) in Abwesenheit von aktinischem Licht nicht reduziert, bei Belichtung den Farbstoff im angeregten Elektronenzustand jedoch reduzieren kann, insbesondere zum Semichinon. Beispiele solcher milden Reduktionsmittel sind Ascorbinsäure, Anethol, Thioharnstoff, Diethylallylthioharnstoff, Hydroxylamin-derivate, insbesondere N-Allylthioharnstoff und bevorzugt Salze des N-Nitrosocyclohexylhydroxylamins, insbesondere die Kalium- und Aluminiumsalze. Letztere sind auch als Inhibitoren gegen die thermische Polymerisation in photopolymerisierbaren Mischungen bekannt. Die Menge der zugesetzten Reduktionsmittel kann im allgemeinen etwa 0,005 bis 5 und insbesondere 0,01 bis 1 Gew.-%, bezogen auf die Gesamtmenge der Komponenten (a)+(b)+(c), soll jedoch nicht weniger als das Reduktionsäquivalent der Menge des verwendeten Farbstoffs (1) betragen. In vielen Fällen hat sich der Zusatz des 3- bis 10-fachen der Menge an mitverwendetem Farbstoff (1) bewährt.

Die Herstellung der wasserauswaschbaren Reliefdruckplatten erfolgt im allgemeinen durch Aufbringen einer homogenen Mischung der Komponenten des lichtempfindlichen Aufzeichnungsmaterials, gegebenenfalls unter Zusatz von Lösungsmittel oder Lösungsmittelgemischen, auf den mit mindestens einer Haft (=Zwischen)schicht versehenen dimensionsstabilen Träger.

Das homogene photopolymerisierbare Gemisch der reliefbildenden Schicht läßt sich auf übliche Weise durch Mischen der Einzelkomponenten in üblichen Mischaggregaten, beispielsweise in Knetern, Extrudern oder Rührkesseln herstellen. Das homogene Gemisch wird dann im allgemeinen in einer Dicke von 25 bis 6000, vorzugsweise 200 bis 1000 µm auf den mit der Haftschicht bzw. mit einer oder mehreren Zwischenschichten versehenen dimensionsstabilen Träger aufgebracht.

Es kann auch vorteilhaft sein, auf die photopolymerisierbare reliefbildende Schicht noch eine Deck- bzw. Schutzschicht aufzubringen, z.B. eine dünne Schicht aus im Entwicklermedium löslichen Polymeren, wie z.B. Polyvinylalkohol oder Polyvinylalkohol-Polyethylenoxid-Copolymerisate.

Die aus dem erfindungsgemäßen lichtempfindlichen Aufzeichnungsmaterial hergestellten photopolymerisierbaren Druckplatten lassen sich in bekannter Weise zu Reliefformen, insbesondere Druckformen, verarbeiten. Hierzu wird im allgemeinen die Schicht des photoempfindlichen Materials bildmäßig mit aktinischem Licht aus Lichtquellen, wie UV-Fluoreszenzröhren, Quecksilberhoch-, -mittel- oder -niederdruckstrahlern, Leuchtstoffröhren etc. belichtet, wobei die emittierte Wellenlänge bevorzugt zwischen 320 und 420 nm liegt. Das Entfernen der unbelichteten und unvernetzten Schichtanteile kann durch Sprühen, Waschen, Bürsten etc. mit wäßrigen Lösungsmitteln oder Wasser erfolgen. Es ist ein Vorteil der erfindungsgemäß hergestellten Druckplatten, daß sie ein Auswaschen der unbelichteten Schichtteile mit reinem Wasser ohne Zusatz organischer Lösungsmittel erlauben. Zweckmäßig werden entwickelte Relief- und Druckformen bei Temperaturen bis zu 120°C getrocknet und gegebenenfalls gleichzeitig oder danach mit aktinischem Licht nachbelichtet.

Die aus erfindungsgemäßen Aufzeichnungsmaterialien hergestellten Druckformen eignen sich besonders für den direkten und indirekten Hochdruck, z.B. für den Buchdruck, den Zeitungsdruck, den Flexodruck, den Zeitungsflexodruck und ähnliche Druckarten.

Die erfindungsgemäßen Druckplatten lassen sich sehr vorteilhaft herstellen und zu Druckformen verarbeiten, die eine gute Flexibilität der Reliefschicht sowie eine deutlich verkürzte Mindestbelichtungszeit bei der Herstellung der Druckformen aufweisen. Weitere Vorteile sind: Hervorragende Auflagenfestigkeit, gutes Farbannahme/Farbabgabe-Verhalten, geringer benötigter Anpreßdruck in der Druckmaschine, geringe Versprödungsneigung sowie eine gute Rißbeständigkeit.

Die Erfindung wird durch die nachstehenden Beispiele erläutert. Die darin genannten Teile und Prozente beziehen sich, soweit nicht anders angegeben, auf das Gewicht. Volumenteile verhalten sich zu Teilen wie Liter zu Kilogramm.

Beispiel 1

Für Zeitungsdruck

294 Teile eines teilverseiften Polyvinylacetats (Hydrolysegrad 82 mol-%; mittleres Molekulargewicht 15000) werden in 294 Teilen Wasser innerhalb einiger Stunden Lösezeit bei 90°C homogen gelöst. Danach kühlt man die Lösung auf ca. 70°C ab und gibt 200 Teile einer Monomermischung aus 180 Teilen Hydroxyethylmethacrylat, 20 Teilen 1,1,1-Trimethylolpropantriacrylat, 50 Teilen ethoxyliertes Glycerin mit 5 bis 18 Ethoxygruppen im Molekül und einem mittleren Ethoxylierungsgrad von 8 Ethoxigruppen pro Mol Glycerin, 10 Teilen 2,4,6-Trimethylbenzoyldiphenylphosphinoxid, 2 Teilen 2,6-Di-t-Butyl-p-kresol sowie 0,1 Teilen Eosin

(Farbstoff, C.I. 45380) unter Rühren zu. Die homogene viskose Lösung wird filtriert, bei vermindertem Luftdruck entgast und so auf ein mit einem Haftlack versehenes Stahlblech beschichtet, daß nach dem Trocknungsschritt (24 h bei Raumtemperatur) eine 0,5 mm dicke photopolymerisierbare Druckplattenschicht resultiert.

Nach einer 2 Sekunden dauernden vollflächigen Vorbelichtung, nach einer 30 Sekunden dauernden Belichtung unter einem Filmnegativ in einem Flachbelichter, bestückt mit superaktinischen Leuchtstoffröhren, anschließendem 2 min. Auswaschen mit 40°C warmem Leitungswasser in einem Sprühwascher und 5 min. Trocknen bei 100°C wurden ausgezeichnete Druckplattenklischees mit scharfem Druckrelief, guten Zwischentiefen, guten mechanischen Eigenschaften, geringer Versprödungsneigung und ausgezeichneter Druckauflagenbeständigkeit erhalten. Ein Auflagendruck von 80000 Drucken auf einer üblichen Zeitungsrotations-Druckmaschine bereitete keine Probleme. Keine der vier aufgespannten erfindungsgemäßen Druckplatten wurde durch den Auflagendruck beschädigt. Die Qualität der gedruckten Zeitung verschlechterte sich während des gesamten Auflagendrucks in keiner Weise.

Vergleichsbeispiel 1

Es wurde exakt wie in Beispiel 1 verfahren, jedoch unterblieb der Zusatz des ethoxylierten Glycerins (erfindungsgemäßer Weichmacher)

Im Gegensatz zum erfindungsgemäßen Vorgehen benötigten diese Platten eine längere Belichtungszeit von 40 Sekunden, eine um 15 % längere Auswaschzeit und weisen eine ausgeprägte Versprödungsneigung, bereits bei Lagerzeiten ab 60 Minuten im Raumklima, auf, die sich in häufigen Beschädigungen des Druckreliefs bereits in den Plattenfördereinrichtungen von der Plattenkopie zur Druckmaschine sowie in Beschädigungen (Abplatzungen u.ä.) während des Auflagendrucks bereits bei relativ niedriger Auflage (< 10000 Drucke) äußerten. Durch diese mechanischen Beschädigungen war die Druck-Qualität so stark beeinträchtigt, daß die Platten bereits nach wenigen tausend Drucken aus der Druckmaschine genommen werden mußten.

Beispiel 2

Für allgemeinen Druck (Akzidenzdruck)

100 Teile eines teilverseiften Polyvinylacetats (Hydrolysegrad 82 mol-%; mittleres Molekulargewicht 15000), 100 Teile methacrylestergruppenhaltiges teilverseiftes Polyvinylacetats, 100 Teile eines statistischen Polyethylenoxid-Polyvinylalkohol-Polyvinylacetat-Copolymeren werden in 300 Teilen Wasser innerhalb einiger Stunden Lösezeit bei 90°C homogen gelöst. Danach kühlt man die Lösung auf ca. 70°C ab und gibt 200 Teile einer Monomermischung aus 200 Teilen Butandiol-bis-glycerinetheracrylat, 50 Teilen ethoxyliertes Glycerin mit 5 bis 18 Ethoxygruppen im Molekül und einem mittleren Ethoxilierungsgrad von 8 Ethoxygruppen pro Mol Glycerin, 10 Teilen Benzildimethylketal, 2 Teilen Cyclohexyldiazeniumdioxy-Kalium sowie 0,1 Teile Safranin O (Farbstoff C.I. 50240) unter Rühren zu. Die homogene viskose Lösung wird filtriert, bei vermindertem Luftdruck entgast, und so auf ein mit einem Haftlack versehenes Stahlblech beschichtet, daß nach dem Trocknungsschritt von 2 Stunden bei einer im Verlauf von 2 Stunden von 60 auf 80°C ansteigenden Trockentemperatur eine 0,7 mm dicke photopolymerisierbare Druckplattenschicht mit einem Restlösemittelgehalt von ca. 5 % resultiert.

Nach 3 min. Belichtung unter einem Filmnegativ in einem Flachbelichter, bestückt mit superaktinischen Leuchtstoffröhren, 3 min. Auswaschen in einem Reibewascher mit 40°C warmem Leitungswasser und 15 min. Trocknen bei 80°C konnten ausgezeichnete und langzeitlagerstabile Druckplattenklischees mit scharfem Druckrelief, guten Zwischentiefen, guten mechanischen Eigenschaften und mit ausgezeichneter Auflagenbeständigkeit erhalten werden. Mit Platten der erfindungsgemäßen Zusammensetzung konnten problemlos 3 Millionen Dosen ohne jede Klischeebeschädigungen bedruckt werden.

Vergleichsbeispiel 2

Es wurde exakt wie in Beispiel 2 verfahren, jedoch unterblieb der Zusatz des ethoxylierten Glycerins (Weichmacher)

Im Gegensatz zum erfindungsgemäßen Vorgehen benötigten diese Platten eine um 30 % längere Trockenzeit, eine längere Belichtungszeit von mindestens 5 Minuten sowie eine um etwa 15 % längere Auswaschzeit. Außerdem lassen sich die Klischees nach dem Auswaschschritt deutlich langsamer trocknen und haben mechanisch schlechtere Eigenschaften. Sie weisen eine höhere Härte auf und erwiesen sich im Dornbiegetest als wesentlich rissanfälliger. Diese Platten zeigten im Praxisdruckversuch von Getränkedosen aus Aluminium Rißprobleme. Die Risse traten während des Auflagendrucks von Getränkedosen bereits nach dem Druck von weniger als 5000 Dosen auf.

Beispiele 3 bis 5

Vergleichsbeispiele 3 bis 16

Es wurde wie in Beispiel 2 verfahren, doch wurden für die Beispiele 3 bis 5 unterschiedliche Mengen an erfindungsgemäß zu verwendendem ethoxyliertem Glycerin, in den Vergleichsbeispielen 4 bis 16 andere Weichmacher und in Vergleichsbeispiel 3 kein Weichmacher eingesetzt. Die Ergebnisse sind in der Tabelle aufgeführt.

Tabelle

| Beispiel Nr. | | Komprimierbarkeit x) [µm Kompr. bei 600 $N/cm^2$] | Belichtungszeit [min] | Dornbiegewert**) [mm] | Reliefkanten***) Abweichung vom Sollzustand [µm] |
|---|---|---|---|---|---|
| 3 | 5 % ethoxyl. Glycerin | 49 | 4 | 12 | < 2 |
| 4 | 10 % ethoxyl. Glycerin | 71 | 4 | 9 | < 2 |
| 5 | 20 % ethoxyl. Glycerin | 79 | 6 | 8 | < 2 |
| Vergl.-Beispiel-Nr. | | | | | |
| 3 | 0 % ethoxyl. Glycerin | 37 | 6 | 20 | < 2 |
| 4 | 10 % Glycerin | 45 | 7 | 15 | 5 |
| 5 | 10 % Ethylenglykol | 48 | 8 | 16 | 6 |
| 6 | 10 % Diglycerin | 47 | 5 | 16 | 5 |
| 7 | 10 % Triglycerin | 42 | 5 | 17 | 4 |
| 8 | 10 % Tetraglycerin | 43 | 6 | 16 | 4 |
| 9 | 10 % Diglykol | 46 | 7 | 15 | 5 |
| 10 | 10 % Polyglycerin $M_w$ = 400 | 40 | 6 | 16 | 4 |
| 11 | 10 % Polyglykol $M_w$ = 300 | 41 | 6 | 16 | 5 |

| Beispiel Nr. | | Komprimierbarkeit x) [µm Kompr. bei 600 $N/cm^2$] | Belichtungszeit [min] | Dornbiegewert **) [mm] | Reliefkanten ***) Abweichung vom Sollzustand [µm] |
|---|---|---|---|---|---|
| 12 | 10 % Neopentylglykol | 42 | 7 | 17 | 5 |
| 13 | 10 % Polytetrahydrofuran $M_w$ = 600 | 40 | 8 | 20 | 3 |
| 14 | 10 % 1,1,1-Trimethylolpropan | 42 | 7 | 16 | 6 |
| 15 | 10 % Trimethylolethan | 45 | 7 | 15 | 6 |
| 16 | 7 % Benzol-n-butylsulfonsäureamid | 45 | 5 | 20 | 3 |

*) Messung am belichteten, ausgewaschenen und getrockneten Klischee mit einem zylinderischen Belastungsstempel des Durchmessers 2 mm; Belastungszeit jeweils 1,0 min.

**) ein 2 cm breiter Klischeestreifen (vollflächig belichtet, ausgewaschen und getrocknet) wird um einen zylindrischen Stahldorn des angegebenen Durchmessers (mm) gebogen. Angegeben wird der Durchmesser, bei dem das Klischee keine Risse mehr aufweist.

***) Messung mit einem Oberflächenabtastgerät (Perthometer® der Fa. Perthen) an einer 200 µm breiten Linie im rechten Winkel zum Linienverlauf. Abweichungen von der Soll-Klischeeoberfläche an den Reliefkanten (= Schulter), die < 2 µm sein sollen.

## Patentansprüche

1. Lichtempfindliches Aufzeichnungsmaterial auf Basis eines Gemisches aus polymerem Bindemittel (a), polymerisierbaren ethylenisch ungesättigten organischen Verbindungen (b) und Weichmacher (c), das zusätzlich mindestens einen Photopolymerisationsinitiator sowie gegebenenfalls weitere übliche Zusatz- und Hilfsstoffe enthält, durch gekennzeichnet, daß es als polymeres Bindemittel (a) teilverseifte Polyvinylcarbonsäureester, Derivate teilverseifter Polyvinylcarbonsäureester oder teilverseifte Polyvinylcarbonsäureestercopolymere, als polymerisierbare ethylenisch ungesättigte organische Verbindungen (b) mindestens ein Umsetzungsprodukt der Acryl- oder Methacrylsäure mit ein- oder mehrwertigen Alkoholen, Amin- oder Epoxidverbindungen und als Weichmacher (c) mindestens ein Ethoxylierungs- oder Propoxylierungsprodukt des Glycerins enthält, in dem pro Mol Glycerin 4 bis 18 Mol Ethylenoxid oder Propylenoxid an eine oder mehrere Hydroxylgruppen des Glycerins addiert sind, und dieser Weichmacher (c) in Mengen von mindestens 5 bis höchstens 25 Gew.-%, bezogen auf die Gesamtmenge der Komponenten (a)+(b)+(c) im lichtempfindlichen Aufzeichnungsmaterial enthalten ist.

2. Verfahren zur Herstellung von wasserauswaschbaren Reliefdruckplatten, im wesentlichen bestehend aus einem Träger, einer Haftschicht und einer darauf angebrachten lichtstrukturierbaren Schicht, dadurch gekennzeichnet, daß als lichtstrukturierbare Schicht das lichtempfindliche Aufzeichnungsmaterial gemäß Anspruch 1 eingesetzt wird.

## Claims

1. A photosensitive recording material based on a mixture of a polymeric binder (a), polymerizable ethylenically unsaturated organic compounds (b) and plasticizers (c), which additionally contains at least one photopolymerization initiator and, if required, further conventional additives and assistants, wherein said recording material contains partially hydrolyzed polyvinylcarboxylates, derivatives of partially hydrolyzed polyvinylcarboxylates or partially hydrolyzed polyvinylcarboxylate copolymers as the polymeric binder (a), at least one reaction product of acrylic or methacrylic acid with monohydric or polyhydric alcohols, amines or epoxide compounds as the polymerizable ethylenically unsaturated organic compounds (b) and at least one ethoxylation or propoxylation product of glycerol, in which from 4 to 18 mol of ethylene oxide or propylene oxide are added to one or more hydroxyl groups of the glycerol per mol of glycerol, as the plasticizer (c), and this plasticizer (c) is present in the photosensitive recording material in an amount of from at least 5 to at most 25% by weight, based on the total amount of components (a)+(b)+(c).

2. A process for the production of a relief printing plate which can be washed out with water and essentially consists of a substrate, an adhesion-promoting layer and a light-structurable layer applied thereon, wherein the photosensitive recording material as claimed in claim 1 is used as the light-structurable layer.

## Revendications

1. Matériau d'enregistrement sensible à la lumière, à base d'un mélange composé d'un liant polymère (a), de combinaisons organiques polymérisables, éthyléniquement insaturées (b) et d'un plastifiant (c), contenant en plus au moins un initiateur de photopolymérisation, ainsi que, le cas échéant, d'autres additifs et auxiliaires usuels, caractérisé en ce qu'il contient, à titre de liant polymère (a), un ester d'acide polyvinylcarboxylique, partiellement saponifié, des dérivés partiellement saponifiés d'ester d'acide polyvinylcarboxylique ou des copolymères d'ester partiellement saponifiés d'ester d'acide polyvinylcarboxylique, à titre de combinaisons organiques polymérisables éthyléniquement insaturées (b) au moins un produit de réaction de l'acide acrylique ou méthacrylique avec des alcools monovalents ou polyvalents, des combinaisons amino ou époxy et, comme plastifiant (c), au moins un produit d'étoxydation ou de propoxylation de la glycérine, dans lequel par mole de glycérine sont ajoutées de 4 à 18 moles d'oxyde d'éthylène ou d'oxyde de propylène sur un ou plusieurs groupes hydroxyle de la glycérine, et ce plastifiant (c) est contenu, dans le matériau d'enregistrement sensible à la lumière, en quantités d'au moins 5 à un maximum de 25 % en poids, par rapport au poids total des composants (a) + (b) + (c).

**2.** Procédé de fabrication de clichés en relief enlevables à l'eau, constitués essentiellement d'un support, d'une couche adhérente et d'une couche photostructurable, appliquée dessus, caractérisé en ce qu'est utilisé, comme couche photostructurable, le matériau d'enregistrement sensible à la lumière selon la revendication 1.